# EUROPÄISCHE PATENTANMELDUNG

(11) **EP 3 696 979 A1**
(43) Veröffentlichungstag der Anmeldung: **19.08.2020**
(21) Anmeldenummer: 19157443.3
(22) Anmeldetag: 15.02.2019
(51) Int. Cl.: H03K 17/082, H03K 17/16

(54) **ELEKTRONISCHER SCHALTER MIT STROMREGULIERUNG**

(71) Anmelder: Siemens Aktiengesellschaft, 80333 München (DE)
(72) Erfinder: Gaudenz, Markus Matthias, 91056 Erlangen (DE)

(57) **Zusammenfassung**

Die Erfindung betrifft einen elektronischen Schalter (1) aufweisend einen Halbleiterschalter (2) mit einer Ansteuerschaltung (3). Zur Verbesserung des elektronischen Schalters (1) wird vorgeschlagen, dass die Ansteuerschaltung (3) derart ausgebildet ist, den Halbleiterschalter (2) pulsweitenmoduliert zu betreiben. Weiter betrifft die Erfindung ein Energieversorgungssystem (10), aufweisend einen derartigen elektronischen Schalter (1), wobei der elektronische Schalter (1) einen ersten Teil (21) des Energieversorgungssystems (10) mit einem zweiten Teil (22) des Energieversorgungssystems (10) trennbar verbindet. Die Erfindung betrifft ferner ein Verfahren zum Betreiben eines derartigen elektronischen Schalters (1) oder eines derartigen Energieversorgungssystems (10), wobei der Halbleiterschalter (2) des elektronischen Schalters (1) zumindest zeitweise pulsweitenmoduliert angesteuert wird.

## Beschreibung

Die Erfindung betrifft einen elektronischen Schalter aufweisend einen Halbleiterschalter mit einer Ansteuerschaltung. Weiter betrifft die Erfindung ein Energieversorgungssystem mit einem derartigen elektronischen Schalter. Die Erfindung betrifft ferner ein Verfahren zum Betreiben eines derartigen elektronischen Schalters oder eines derartigen Energieversorgungssystems.

Schalter werden heutzutage unter anderem dazu genutzt, um in Energieversorgungssystemen elektrische Verbraucher vom Netz trennen zu können. Ebenso ist es mit Hilfe des Schalters möglich, Teile eines Energieversorgungsnetzes abzuschalten bzw. unterschiedliche Teile des Energieversorgungssystems miteinander zu verbinden oder voneinander zu trennen. Das Trennen kann dabei aus betrieblichen Gründen vorgenommen werden oder auch zum Schutz von Komponenten des Energieversorgungssystems bei Auftreten eines Fehlers. Dabei lässt sich mit dem Schalter beispielsweise ein Strang oder mehrere Stränge mit jeweils einem oder mehreren daran angeschlossenen elektrischen Verbrauchern von der Energiequelle oder den Energiequellen des Energieversorgungssystems trennen.

Heutzutage wird bei Auftreten eines Fehlers der betroffene Teil vom Energieversorgungssystem getrennt, um den verbleibenden Teil des Energieversorgungssystems in Betrieb halten zu können. Dazu kommen sowohl mechanische wie auch elektronische Schalter zum Einsatz.

Energieversorgungssystem sind heutzutage meistens als AC Netze ausgeführt. Verschiedene Spannungsebenen können dann auf einfache Weise mittels Transformatoren realisiert werden. Der Schutz einzelner Abgänge oder der einzelnen Spannungsebenen wird dabei meist über mechanische Schalter realisiert. Dabei wird in einem EIN Zustand, auch als eingeschalteter Zustand oder leitender Zustand bezeichnet, eine leitende Verbindung geschaffen, während im AUS Zustand, auch als ausgeschalteter Zustand oder nichtleitender Zustand bezeichnet, die Eingangs- und Ausgangsanschlüsse des Schalters voneinander elektrisch isoliert sind. Die Umschaltung zwischen EIN und AUS Zustand erfolgt im mechanischen Schalter durch die Bewegung eines stromleitenden Elements.

Neben mechanischen Schaltern sind auch Schalter auf Basis von Halbleiterschaltern bekannt. Diese Schalter werden als elektronische Schalter bezeichnet. Sie zeichnen sich dadurch aus, dass diese sehr schnell schalten können. Darüber hinaus benötigen diese Schalter für das Abschalten keinen Stromnulldurchgang, so dass sich diese elektronischen Schalter auch insbesondere für die Anwendung in einem Gleichspannungsnetz eignen.

Der Erfindung liegt die Aufgabe zugrunde, einen elektronischen Schalter zu verbessern.

Diese Aufgabe wird durch einen elektronischen Schalter aufweisend einen Halbleiterschalter mit einer Ansteuerschaltung gelöst, wobei die Ansteuerschaltung derart ausgebildet ist, den Halbleiterschalter pulsweitenmoduliert zu betreiben. Diese Aufgabe wird ferner durch ein Energieversorgungssystem, aufweisend einen derartigen elektronischen Schalter gelöst, wobei der elektronische Schalter einen ersten Teil des Energieversorgungssystems mit einem zweiten Teil des Energieversorgungssystems trennbar verbindet. Weiter wird diese Aufgabe durch ein Verfahren zum Betreiben eines derartigen elektronischen Schalters oder eines derartigen Energieversorgungssystems gelöst, wobei der Halbleiterschalter des elektronischen Schalters zumindest zeitweise pulsweitenmoduliert angesteuert wird.

Weitere vorteilhafte Ausgestaltungen der Erfindung sind in den abhängigen Ansprüchen angegeben.

Der Erfindung liegt die Erkenntnis zugrunde, dass sich ein elektronischer Schalter dadurch verbessern lässt, dass dieser zumindest zeitweise pulsweitenmoduliert betrieben wird. Dabei wird der Halbleiterschalter mit einer Pulsfrequenz ein- und ausgeschaltet. Das Verhältnis von der Zeitdauer, bei dem der Halbleiterschalter leitend ist zu der Summe der Zeitdauer im leitenden und gesperrten Zustand wird als Aussteuergrad bezeichnet. Die Summe der Zeitdauer im leitenden und gesperrt Zustand entspricht der Periodendauer der Pulsweitenmodulation bzw. dem Kehrwert der Pulsfrequenz. Bei einem Aussteuergrad von 0 oder 0% ist der Schalter ausgeschaltet oder nichtleitend, bei einem Aussteuergrad von 1 oder 100% ist der Schalter leitend. Bei allen Werten dazwischen finden Schalthandlungen mit der Pulsfrequenz statt, die einen Spannungsabfall über den elektronischen Schalter sowie eine Reduktion des Stroms durch den elektronischen Schalter bewirken. Der Aussteuergrad wird auch als Tastgrad oder englisch als duty cycle bezeichnet.

Der Einsatz eines elektronischen Schalters zur Umsetzung von Schalthandlungen, insbesondere von Schutzfunktionen, in einem Energieversorgungssystem bietet Freiheitsgerade. Neben den typischen Schaltzuständen EIN und AUS eines Schalters bietet der elektronische Schalter die Möglichkeit, die elektrische Leistung, die durch den elektronischen Schalter übertragen wird, mittels der Pulsweitenmodulation zu steuern oder zu regeln. Damit kann im Fehlerfall anstelle eines Abschaltens des fehlerbehafteten Stranges oder des fehlerhaften Verbrauchers auch eine Leistungsreduktion oder eine Stromreduktion vorgenommen werden. Droht zum Beispiel eine Überlastung, kann die über den elektronischen Schalter übertragene Leistung bzw. der Strom derart reduziert werden, dass ein Betrieb der angeschlossenen Komponenten weiterhin möglich ist. Dazu kann beispielsweise der Strom und/oder die Spannung des entsprechenden Stranges reduziert werden. Durch die Strombegrenzung, beispielsweise für einen ohmschen Verbraucher durch Reduktion der Spannung kann dann der Strang bei verminderter Leistung in Betrieb bleiben. Durch eine Spannungsreduktion kann darüber hinaus ein geregelter elektrischer Verbraucher wie beispielsweise ein Stromrichter erkennen, dass die zur Verfügung stehende Leistung begrenzt ist und führt dann von sich aus eine Leistungsreduktion aus.

Neben der reinen Leistungsreduktion kann auch eine Quelle mit erhöhtem Innenwiderstand nachgebildet werden. Dieser dann vorhandene hohe Innenwiderstand verhindert Beschädigungen oder Zerstörungen im fehlerhaften Strang durch eine Strombegrenzung, so dass empfindliche Lasten mit einem derartigen Schalter auch im Fehlerfall noch mit Energie versorgt werden können und nicht unvermittelt abgeschaltet werden müssen. Erst wenn diese Leistungsreduktion, beispielsweise über einen Strommaximalwert oder einen Innenwiderstand einer virtuellen Quelle definiert, nicht zu dem gewünschten Ergebnis führt, kann mittels einer Schalthandlung in den nichtleitenden Zustand des elektronischen Schalters der Strang komplett vom restlichen Teil des Energieversorgungssystems getrennt werden. Dazu können dann mehrere Auslöseschwellen definiert werden. Bis zu einem bestimmten ersten Grenzwert ist der elektronische Schalter im Schaltzustand EIN. Oberhalb dieses ersten Grenzwertes reduziert der elektronische Schalter den Strom und/oder die Spannung, so dass sich die übertragene Leistung bzw. der übertragene Strom reduziert. Erst bei einem zweiten Grenzwert, der sinnvollerweise größer ist als der erste Grenzwert, wird der Schalter in den AUS Zustand versetzt. Bei den Grenzwerten kann es sich beispielsweise um Ströme, Spannungen oder Leistungen handeln.

Dies funktioniert sowohl für Netze oder Systeme mit einer Wechselspannung als auch für Netze oder Systeme mit einer Gleichspannung.

Der Vorteil des pulsweitenmodulierten Betriebs als dritter Zustand des elektronischen Schalters neben dem EIN Zustand und dem AUS Zustand besteht unter anderem darin, dass Teile des Energieversorgungsnetzes bei Vorliegen eines Fehlers nicht zwangsweise abgeschaltet werden müssen, sondern weiterhin im Betrieb bleiben können, sofern sich durch eine Steuerung/Regelung des Energieflusses das Teilnetz vor Überlastung schützen lässt. Das kann dabei beispielsweise direkt (ohmsche Last reduziert automatisch Leistung bei geringerer Versorgungsspannung) geschehen als auch indirekt, dass ein gesteuerter oder geregelter elektrischer Verbraucher (bspw. ein Stromrichter, ein Batterieladegerät, etc.) die geringere Versorgungsspannung erkennt und darauf durch seine eigene Regelung/Steuerung die aufgenommene Leistung reduziert. Damit wird die Verfügbarkeit des Energieversorgungssystems deutlich erhöht und gleichzeitig über den zweiten Grenzwert die Sicherheit vor Überlastung genauso zuverlässig sichergestellt wie es mit einem mechanischen Schalter möglich ist.

Bei einer vorteilhaften Ausgestaltung der Erfindung weist der elektronische Schalter einen Stromsensor auf, wobei in Abhängigkeit von Messwerten des Stromsensors der Aussteuergrad der Pulsweitenmodulation bestimmbar ist. Der Stromsensor ist besonders vorteilhaft, wenn der Strom durch den elektronischen Schalter gesteuert oder geregelt werden soll. Dann kann der Messwert des Stroms direkt in der Regelung des elektronischen Schalters verwendet werden. Im fehlerfreien Betrieb, der anhand des Strommesswertes erkannt werden kann, bleibt der elektronische Schalter im EIN Zustand. Für den Schutz können dann zwei Grenzwerte festgelegt werden. Mit Überschreiten eines ersten Grenzwertes wird dann der Schalter Pulsweitenmoduliert betrieben, um den Strom zu begrenzen. Bei Überschreiten eines zweiten Grenzwertes, der größer ist als der erste Grenzwert, wird dann der elektronische Schalter ausgeschaltet.

Beim Betrieb mit Pulsweitenmodulation hat es sich als vorteilhaft erwiesen, dass der elektronische Schalter und/oder das Energieversorgungssystem einen Stromsensor aufweisen, wobei in Abhängigkeit von Messwerten des Stromsensors der Aussteuergrad der Pulsweitenmodulation bestimmt wird. Wenn der Strom weiter reduziert werden soll, so wird der Aussteuergrad weiter verringert. Dies kann so lange geschehen, bis der Aussteuergrad den Wert 0 erreicht hat. Bei diesem Wert ist der elektronische Schalter geöffnet, also nichtleitend. Es ist zwar besonders vorteilhaft, wenn der Stromwandler bereits im elektronischen Schalter angeordnet ist, da damit auch seine Messwerte ohne aufwendige Datenschnittstelle der Regelung des elektronischen Schalters bekannt sind. Allerdings ist es auch möglich, den Stromsensor außerhalb des elektronischen Schalters anzuordnen. Sinnvoll ist eine Anordnung dort, wo ein Strom gemessen wird, der zumindest anteilig durch den elektronischen Schalter fließt, da dieser Strom dann durch den elektronischen Schalter beeinflussbar ist. Mit anderen Worten ist die Anordnung des Stromsensors dort vorteilhaft, wo mit dem Stromsensor ein Strom gemessen wird, der zumindest anteilig durch den elektronischen Schalter fließt.

Ebenso ist es möglich, sowohl einen Stromwandler des elektronischen Schalters als auch einen Stromwandler an anderer Stelle des Energieversorgungssystems auszuwerten und daraus den Aussteuergrad für den Halbleiterschalter des elektronischen Schalters zu bestimmen.

Bei einer weiteren vorteilhaften Ausgestaltung der Erfindung ist das Energieversorgungssystem als Gleichspannungsnetz ausgebildet. Besonders vorteilhaft ist die Anwendung für DC Netze, weil der elektronische Schalter besonders gut geeignet ist, auch Ströme ohne Nulldurchgang zu schalten, was ihn im Vergleich zu einem mechanischen Schalter besonders kompakt macht. Darüber hinaus ist der Einsatz in DC Netzen besonders vorteilhaft, da der Schalter auf besonders einfache Weise durch Verwendung der Pulsweitenmodulation auch als DC/DC Steller betrieben werden kann. Bei einem DC/DC Steller wird im Gegensatz zu einem Stromrichter für AC Anwendungen nur ein abschaltbarer Halbleiterschalter benötigt, wie er im elektronischen Schalter bereits vorhanden ist.

Zur Reduktion der Spannung wird dann der Halbleiterschalter pulsmoduliert angesteuert. Dabei ist ein Betrieb bei geringen elektrischen Verlusten möglich. Damit wird mit dem Schalter ein DC/DC Steller realisiert, indem über den elektronischen Schalter eine Spannung abfällt und die ausgangsseitige Spannung (an dem lastseitigen Anschluss des elektronischen Schalters gegenüber dem Bezugspotential) gegenüber der eingangsseitigen Spannung (an dem quellenseitigen Anschluss des elektronischen Schalters gegenüber dem Bezugspotential) um diesen Betrag reduziert.

Bei einer weiteren vorteilhaften Ausgestaltung der Erfindung ist der elektronische Schalter an mindestens einem seiner Anschlüsse mit einer Diode verbunden. Wird mit dem elektronischen Schalter ein elektrischer Verbraucher mit einem Gleichspannungsnetz verbunden, so kann es vorteilhaft sein, an dem Anschluss des elektronischen Schalters, der mit dem elektrischen Verbraucher verbunden ist, eine Diode anzuordnen. Die Diode wird dann zwischen den Potentialen angeordnet, die den elektrischen Verbraucher mit Spannung versorgen. Dabei ist die Diode so gepolt, dass sie die anliegende Spannung sperrt. Gerade für induktive Verbraucher ist dies vorteilhaft, da durch das Abschalten des elektronischen Schalters dadurch Überspannungen am Schalter und/oder am elektrischen Verbraucher zuverlässig verhindert werden. Die Diode hat keine Nachteile, wenn sie auf der Seite des elektronischen Schalters angeordnet ist, die mit der Energiequelle verbunden ist. Daher ist es für einen universellen Einsatz des elektronischen Schalters möglich, beide Anschlüsse des elektronischen Schalters jeweils mit einer entsprechenden Diode auszustatten.

Bei einer weiteren vorteilhaften Ausgestaltung der Erfindung ist der elektronische Schalter an mindestens einem seiner Anschlüsse mit einem Kondensator verbunden. Auch am quellenseitigen Anschluss des elektronischen Schalters können durch das Schalten, gerade bei der Pulsweitenmodulation Überspannungen entstehen. Diese Überspannungen sind umso größer, je größer das induktives Verhalten an diesem Anschluss ist. Durch einen Kondensator, der unter anderem in einem Gleichspannungsnetz auch zur Spannungsstützung dient, können diese Überspannungen reduziert werden. Dabei kann der Schalter auch Teil eines Netzfilters sein, das dazu vorgesehen ist, unerwünschte Ströme im Energieversorgungssystem zu beseitigen.

Bei einer weiteren vorteilhaften Ausgestaltung der Erfindung wird der Halbleiterschalter des elektronischen Schalters bei einem Wechsel zwischen einem leitenden Zustand und einem nichtleitenden Zustand für eine Zeitdauer pulsweitenmoduliert angesteuert. Dieser Zwischenschritt vom eingeschalteten Zustand zum ausgeschalteten Zustand und/oder vom ausgeschalteten Zustand zum eingeschalteten Zustand macht den Übergang für die beiden Teilnetze oder auch für einzelne elektrische Verbraucher wie auch Energiequellen besonders schonend. Damit ist gemeint, dass dadurch oftmals Überspannungen und/oder Überströme, welche die Lebensdauer des Verbrauchers oder der Quelle beeinflussen können, reduziert oder beseitigt werden. Viele Verbraucher, insbesondere Verbraucher mit kapazitivem oder ohmsch-kapazitivem Verhalten verursachen hohe Einschaltströme. Durch diesen Zwischenschritt können diese Einschaltströme zum Teil erheblich reduziert werden. Vorteilhaft für diese Steuerung oder Regelung ist, dass kein Messwert dafür benötigt wird. Das Einschalten oder Ausschalten des elektronischen Schalters kann sensorlos erfolgen und dabei hohe Einschaltströme oder Spannungsschwankungen vermeiden.

Dazu kann beim Einschalten der Aussteuergrad kontinuierlich, aber nicht notwendigerweise linear, von 0% auf 100% erhöht werden. Beim Ausschalten wird dann der Aussteuergrad von 100% auf 0% kontinuierlich, aber nicht notwendigerweise linear, reduziert. Somit lässt sich auf einfache Weise der Zwischenschritt der Pulsweitenmodulation in ein Schalten zwischen den Zuständen EIN und AUS integrieren.

Bei einer weiteren vorteilhaften Ausgestaltung der Erfindung ist bei einem ersten Aussteuergrad, der kleiner ist als ein zweiter Aussteuergrad, eine Flankensteilheit eines Pulses der Pulsweitenmodulation bei dem ersten Aussteuergrads kleiner als die Flankensteilheit eines Pulses der Pulsweitenmodulation bei dem zweiten Aussteuergrad. Bei einem idealen und damit verlustfreien Schalten sind die Schaltflanken senkrecht. Das heißt es liegt eine unendliche Flankensteilheit vor. In der Realität wird es immer, wenn auch nur eine noch so kleine Zeitdauer vergehen, bei dem der Schalter vom leitenden in den nichtleitenden Zustand übergeht und die Spannung am lastseitigen Anschluss sich entsprechend ändert. Da während des Übergangs sowohl Spannung am Halbleiterschalter als auch Strom durch den Halbleiterschalter anstehen, entstehen während des Schaltvorgangs elektrische Verluste. Diese Verluste werden größer, wenn die Flankensteilheit abnimmt. Dieses Verhalten kann in positiver Weise genutzt werden. Falls der Halbleiterschalter in Pulsweitenmodulation betrieben wird, kann davon ausgegangen werden, dass vermutlich ein Fehler oder zumindest ein unerwünschter Effekt im Energieversorgungssystem vorliegt. Wenn dazu der Aussteuergrad schon entsprechend klein ist, um den Strom zu begrenzen, heißt das, dass selbst wenn der elektronische Schalter schon nahe an der Grenze zum geöffneten Zustand betrieben wird, immer noch ein hoher Strom vorhanden ist. Dies könnte auf einen Kurzschluss oder Schwingungen im Energieversorgungssystem hinweisen. Aufgrund der großen Ströme können dann auch weitere Schwingungen im Energieversorgungssystem angeregt werden. Um jedoch Schwingungen zu dämpfen sind Verluste erforderlich. Diese können dann bei niedrigem Aussteuergrad in Form von geringeren Flankensteilheiten auf einfache Weise in das Energieversorgungssystem eingebracht werden und dieses damit auf einfache Weise stabilisieren. Zudem ist das Frequenzspektrum bei geringer Flankensteilheit deutlich geringer, so dass ein Anregen von im Netz vorhandenen Resonanzen deutlich unwahrscheinlicher wird. Damit werden Anregungen im Energieversorgungssystem beseitigt und sogar ein dämpfendes Verhalten mit den reduzierten Flankensteilheiten erzeugt. Zusammen kann damit das Energieversorgungssystem stabilisiert werden.

Diese Funktion ist sehr robust, da hierfür auch keine Messwerte für die Steuerung benötigt werden. Es hat sich gezeigt, dass gerade bei kleinen Aussteuergraden, bei denen schon eine große Stellreserve für das Begrenzen der Leistung und/oder des Stroms verwendet werden, das Energieversorgungssystem auf einfache Weise durch eine geringe Flankensteilheit beim Takten des Halbleiterschalters stabilisiert werden kann. Gleichzeitig wird damit ein zweistufiges Konzept realisiert, bei dem in einer ersten Stufe die Pulsweitenmodulation versucht, Ströme zu begrenzen und erst in einem zweiten Schritt, bei dem die Pulsweitenmodulation an die Grenzen ihrer Stellmöglichkeiten kommt, das Energieversorgungssystem durch erzeugte Verluste im Halbleiterschalter stabilisiert und gedämpft wird. Die Verluste bewirken ein ohmsches Verhalten, was die übertragenen Ströme und Leistungen weiter reduziert.

Im Folgenden wird die Erfindung anhand der in den Figuren dargestellten Ausführungsbeispiele näher beschrieben und erläutert. Es zeigen:
- FIG 1: einen elektronischen Schalter,
- FIG 2: ein Energieversorgungssystem und
- FIG 3 bis FIG 6: Zeitverläufe verschiedener Größen.

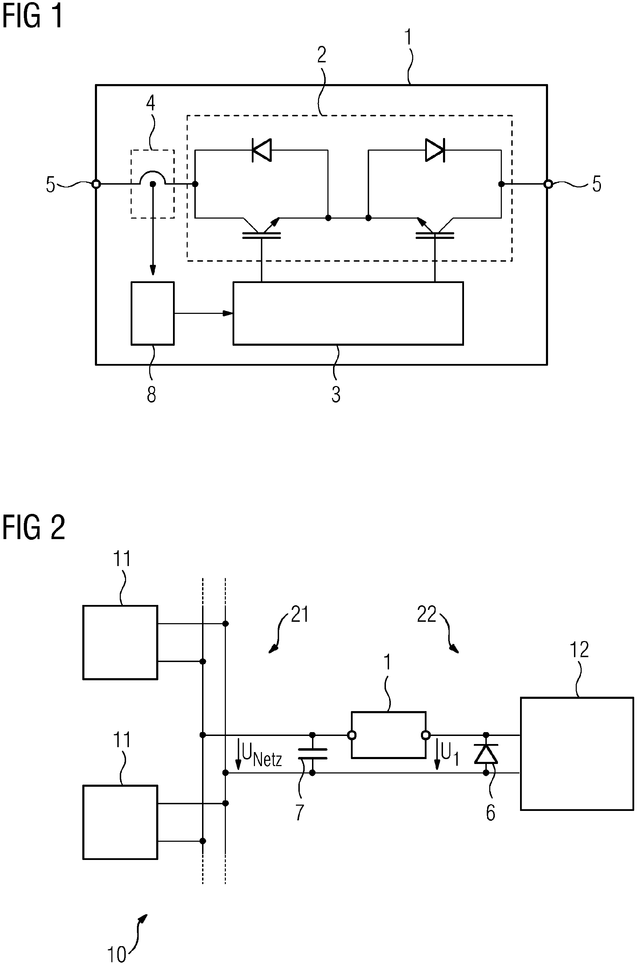

Die FIG 1 zeigt einen elektronischen Schalter 1. Dieser weist einen Halbleiterschalter 2 auf, der mit seinen zwei Halbleitern einen Strom in beide Richtungen führen und abschalten kann. Angesteuert wird der Halbleiterschalter 2 mit seinen Halbleitern von einer Ansteuerschaltung 3. Diese Ansteuerschaltung 3 ermöglicht es, den Halbleiterschalter 2 und damit die darin angeordneten Halbleiter, in einem eingeschalteten Zustand, in einem ausgeschalteten Zustand und pulsweitenmoduliert zu betreiben. Der eingeschaltete Zustand wird auch als leitender Zustand, geschlossener Zustand oder EIN-Zustand bezeichnet. Der ausgeschaltete Zustand wird auch als nichtleitender Zustand, geöffneter Zustand oder AUS-Zustand bezeichnet. Bei dem pulsweitenmodulierten Betrieb wird der Halbleiterschalter 2 mit der Pulsfrequenz getaktet. Aus dem zeitlichen Verhältnis von eingeschaltetem Zustand zu ausgeschaltetem Zustand ergibt sich im zeitlichen Mittel die Ausgangsspannung am Ausgang des elektronischen Schalters 1. Das Verhältnis von Zeitdauer des eingeschalteten Zustands zu Periodendauer (entspricht dem Kehrwert der Pulsfrequenz) ist der Aussteuergrad a. Die Bestimmung oder Berechnung des Aussteuergrads a kann durch die Regelung/Steuerung 8 des elektronischen Schalters 1 in Abhängigkeit von Messwerten eines Stromwandlers 4 geschehen. Dieser kann, wie dargestellt, im elektronischen Schalter 1 angeordnet sein oder sich an anderer Stelle im Energieversorgungssystem 10 befinden. Auch ist es möglich, beim Betrieb des elektronischen Schalters 1 die Pulsweitenmodulation unabhängig von Messwerten eines Stromsensors 4 vorzusehen. Eine entsprechende Regelung wäre dann sensorlos.

Mit der Pulsweitenmodulation können dann Ströme oder Leistungen durch den elektronischen Schalter 1 reduziert werden. Zusätzlich ist es darüber hinaus möglich, durch Anpassung der Flankensteilheit bei den Pulsen der Pulsweitenmodulation mittels elektrischer Verluste stabilisierend und strommindernd auf das Energieversorgungssystem 10 einzuwirken.

Die FIG 2 zeigt ein Energieversorgungssystem 10, bei dem mittels des elektronischen Schalters 1 ein erster Teil 21 des Energieversorgungssystems 10 mit einem zweiten Teil 22 des Energieversorgungssystems 10 verbunden ist. Der erste Teil 21 weist dabei Energiequellen 11 auf, die das Energieversorgungssystem 10 mit elektrischer Energie versorgen. Der zweite Teil 22 weist einen elektrischen Verbraucher 12 auf. Dieser kann mit Hilfe des elektrischen Schalters 1 von der Energieversorgung getrennt werden. Darüber hinaus können beide Teile 21, 22 als Teilnetze darüber hinaus jeweils noch weitere Energiequellen 11 und elektrische Verbraucher 12 aufweisen. Zur Verbesserung des Schaltverhaltens ist an dem quellenseitigen Anschluss 5 des elektronischen Schalters 1 ein Kondensator 7 angeordnet. Dieser reduziert mögliche Überspannungen bei Schalthandlungen am elektronischen Schalter 1. Zudem stützt der Kondensator 7 die Eingangsspannung am elektronischen Schalter 1, wenn dieses Energieversorgungssystem 10 als Gleichspannungsnetz ausgebildet ist und wirkt sich somit positiv auf die Stabilität des Energieversorgungsnetzes 10 aus. Zum Schutz vor weiteren Überspannungen am elektronischen Schalter 1 oder dem elektrischen Verbraucher 12 ist am lastseitigen Anschluss 5 des elektronischen Schalters 1 eine Diode 6 angeordnet. Diese ist nur sinnvoll in einem Gleichspannungsnetz einsetzbar und schützt hier die Komponenten, insbesondere induktiven Lasten als elektrische Verbraucher 12, vor einer Überspannung.

Zur Messung von Strömen, die von dem elektronischen Schalter 1 zu regulieren sind, kann darüber hinaus zusätzlich oder alternativ zu einem Stromsensor 4 im elektronischen Schalter 1 der Stromsensor 4 auch an einer anderen Stelle in das Energieversorgungssystem 10 außerhalb des elektronischen Schalters 1 angeordnet werden. Dabei sollte der gemessene Strom zumindest teilweise durch den elektronischen Schalter 1 fließen, der die Messwerte von dem entsprechenden Wandler aufnimmt.

An dem quellenseitigen Anschluss 5 des elektronischen Schalters 1 liegt die Netzspannung U_{Netz} an, während an dem lastseitigen Anschluss 5 des elektronischen Schalters 1 die Ausgangsspannung U₁ anliegt. Der zeitliche Verlauf bei einem Betrieb mit Pulsweitenmodulation wird in den nächsten Figuren näher beschrieben und erläutert.

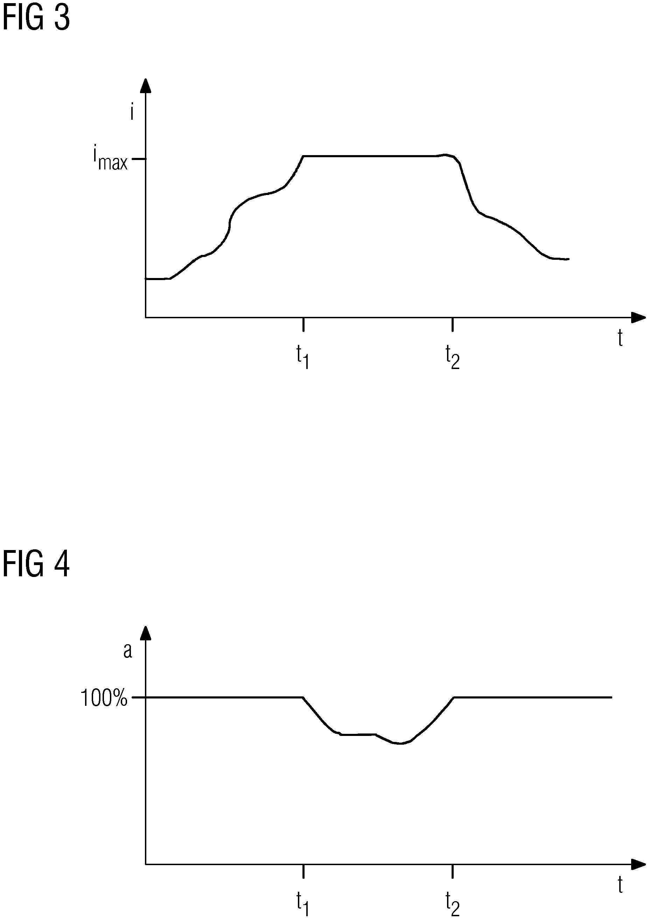

Die FIG 3 zeigt beispielhaft einen zeitlichen Verlauf eines Stromes, den ein Verbraucher 12 aufnimmt, der sich beispielsweise in einer Anordnung nach FIG 2 befindet. Die FIG 4 zeigt den dazugehörigen zeitlichen Verlauf des Aussteuergrads a des elektronischen Schalters 1, der den elektrischen Verbraucher 12 mit den Energiequellen 11 verbindet. Bis zum Zeitpunkt t₁ ist der Schalter eingeschaltet, erkennbar am Aussteuergrad von 100%. Zu diesem Zeitpunkt t₁ erreicht der Strom seinen maximal zulässigen Wert und droht, diesen Wert zu überschreiten. Ab diesem Zeitpunkt wird der elektronische Schalter 1 mit Pulsweitenmodulation betrieben. Die Regelung senkt den Aussteuergrad auf Werte unter 100% und hält damit den Strom auf einem konstanten Wert, beispielsweise auf dem maximal zulässigen Wert. Zum Zeitpunkt t2 ist keine Überlastung mehr vorhanden. Der elektronische Schalter 1 ist wieder eingeschaltet (Aussteuergrad ist 100%) und der elektrische Verbraucher 12 nimmt den benötigten Strom auf, der unterhalb des zulässigen Wertes liegt.

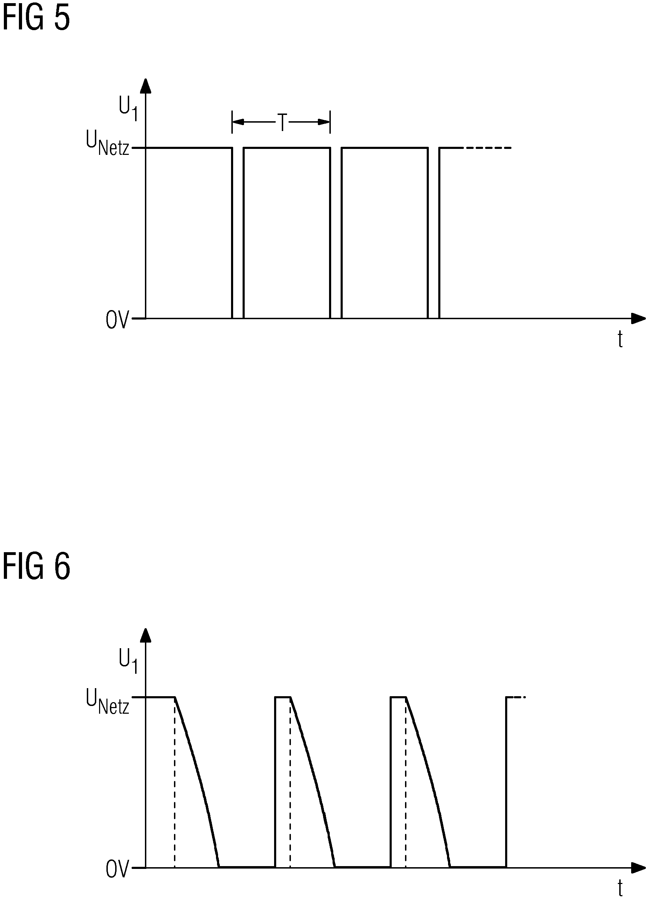

Die FIG 5 zeigt einen zeitlichen Verlauf der Spannung U₁ am lastseitigen Anschluss des Halbleiterschalters 2 gegenüber einem Bezugspotential bei einem hohen Aussteuergrad a. Eingezeichnet ist die Periodendauer T der Schalthandlungen. Wenn der elektronische Schalter eingeschaltet, also leitend, ist, liegt an dem lastseitigen Anschluss die Netzspannung U_{Netz} gegenüber dem Bezugspotential an. Im ausgeschalteten Zustand liegen 0V an.

Da die Zeit im EIN Zustand deutlich größer ist als die Zeit im AUS Zustand ist der Aussteuergrad deutlich über 50%. Bei diesen hohen Aussteuergraden sollen die Verluste möglichst gering gehalten werden. Daher sind die Schaltflanken nahezu senkrecht dargestellt. Dies entspricht einer hohen Flankensteilheit, insbesondere einer unendlichen Flankensteilheit. Einen vergleichbaren Zeitverlauf zeigt FIG 6 jedoch mit einem relativ geringen Aussteuergrad a von deutlich unter 50%. Hier können die Verluste des Halbleiterschalters 2 sich durchaus dämpfend und stromsenkend auf das Energieversorgungssystem 10, insbesondere auf den elektrischen Verbraucher 12, auswirken. Daher hat es sich als vorteilhaft erwiesen, die Steilheit der Schaltflanke mit abnehmenden Aussteuergrad a zu reduzieren. Die Flankensteilheit ist also bei einem geringen Aussteuergrad a auch geringer. So kann beispielsweise bei Werten des Aussteuergrads von über 50% die Flankensteilheit den durch die Ansteuerschaltung maximal erreichbaren Wert annehmen, während er bei Aussteuerungen a unterhalb von 50% kontinuierlich oder in Stufen abgesenkt wird. Die Anzahl der Stufen kann dabei beliebig gewählt werden. Diese Absenkung kann sich auf die fallende Flanke beziehen, wie in FIG 6 dargestellt oder auf die steigende Flanke. Des Weiteren können auch beide Schaltflanken, d.h. die fallende und die steigende Flanke mit einer abgesenkten Flankensteilheit versehen werden. Gestrichelt dargestellt ist noch der Zeitverlauf, der Spannung am lastseitigen Anschluss des elektronischen Schalters gegenüber dem Bezugspotential, wenn keine Absenkung der Flankensteilheit vorgenommen wird.

Zusammenfassend betrifft die Erfindung einen elektronischen Schalter aufweisend einen Halbleiterschalter mit einer Ansteuerschaltung. Zur Verbesserung des elektronischen Schalters wird vorgeschlagen, dass die Ansteuerschaltung derart ausgebildet ist, den Halbleiterschalter pulsweitenmoduliert zu betreiben. Weiter betrifft die Erfindung ein Energieversorgungssystem, aufweisend einen derartigen elektronischen Schalter, wobei der elektronische Schalter einen ersten Teil des Energieversorgungssystems mit einem zweiten Teil des Energieversorgungssystems trennbar verbindet. Die Erfindung betrifft ferner ein Verfahren zum Betreiben eines derartigen elektronischen Schalters oder eines derartigen Energieversorgungssystems, wobei der Halbleiterschalter des elektronischen Schalters zumindest zeitweise pulsweitenmoduliert angesteuert wird.

## Patentansprüche

1. Elektronischer Schalter (1) aufweisend einen Halbleiterschalter (2) mit einer Ansteuerschaltung (3), wobei die Ansteuerschaltung (3) derart ausgebildet ist, den Halbleiterschalter (2) pulsweitenmoduliert zu betreiben.

2. Elektronischer Schalter (1) nach Anspruch 1, wobei der elektronische Schalter (1) einen Stromsensor (4) aufweist, wobei in Abhängigkeit von Messwerten des Stromsensors (4) der Aussteuergrad der Pulsweitenmodulation bestimmbar ist.

3. Energieversorgungssystem (10), aufweisend einen elektronischen Schalter (1) nach einem der Ansprüche 1 oder 2, wobei der elektronische Schalter (1) einen ersten Teil (21) des Energieversorgungssystems (10) mit einem zweiten Teil (22) des Energieversorgungssystems (10) trennbar verbindet.

4. Energieversorgungssystem (10) nach Anspruch 3, wobei das Energieversorgungssystem (10) als Gleichspannungsnetz ausgebildet ist.

5. Energieversorgungssystem (10) nach Anspruch 4, wobei der elektronische Schalter (1) an mindestens einem seiner Anschlüsse (5) mit einer Diode (6) verbunden ist.

6. Energieversorgungssystem (10) nach einem der Ansprüche 3 bis 5, wobei der elektronische Schalter (1) an mindestens einem seiner Anschlüsse (5) mit einem Kondensator (7) verbunden ist.

7. Verfahren zum Betreiben eines elektronischen Schalters (1) nach einem der Ansprüche 1 oder 2 oder eines Energieversorgungssystems (10) nach einem der Ansprüche 4 bis 6, wobei der Halbleiterschalter (2) des elektronischen Schalters (1) zumindest zeitweise pulsweitenmoduliert angesteuert wird.

8. Verfahren nach Anspruch 7, wobei der Halbleiterschalter (2) des elektronischen Schalters (1) bei einem Wechsel zwischen einem leitenden Zustand und einem nichtleitenden Zustand für eine Zeitdauer pulsweitenmoduliert angesteuert wird.

9. Verfahren nach einem der Ansprüche 7 oder 8, wobei der elektronische Schalter (1) und/oder das Energieversorgungssystem (10) einen Stromsensor (4) aufweisen, wobei in Abhängigkeit von Messwerten des Stromsensors (4) der Aussteuergrad (a) der Pulsweitenmodulation bestimmt wird.

10. Verfahren nach einem der Ansprüche 7 bis 9, wobei bei einem ersten Aussteuergrad (a₁), der kleiner ist als ein zweiter Aussteuergrad (a₂), eine Flankensteilheit eines Pulses der Pulsweitenmodulation bei dem ersten Aussteuergrads (a₁) kleiner ist als die Flankensteilheit eines Pulses der Pulsweitenmodulation bei dem zweiten Aussteuergrad (a₂).
